# EUROPEAN PATENT APPLICATION

(11) **EP 1 443 547 A2**
(43) Date of publication of application: **04.08.2004**
(21) Application number: 04001772.5
(22) Date of filing: 28.01.2004
(51) Int. Cl.: H01L 21/56, H01L 23/31

(54) **Method for efficient capillary underfill**

(30) Priority: 28.01.2003 US 443029 P; 27.01.2004 US 765598
(71) Applicant: NORDSON CORPORATION, Westlake, Ohio 44145-1119 (US)
(72) Inventor: Quinones, Horatio, Carlsbad CA 92009 (US); Fiske, Erik, Carlsbad CA 92008 (US); Ratledge, Thomas Laferi, San Marcos CA 92078 (US); Babiarz, Alec, Encinitas CA 92024 (US); Ciardella, Robert L., Rancho Santa Fe CA 92067 (US)
(74) Representative: Eisenführ, Speiser & Partner

(57) **Abstract**

Methods for underfilling a gap between a component (12) and a component carrier (14), such as a die (12) joined to a substrate (14) by solder electrical interconnections, with an underfill material (26). One or more chambers or passageways (16) are provided in either the component carrier (14) at a location beneath the intended position of the component (12) or in the component (12) itself. The component (12) and component carrier (14) are heated and a volume of underfill material (26) is introduced into each passageway (16). After introduction, the underfill material (26) flows or moves to fill the gap (28) between the component and the component carrier. A fillet (38,40) may be optionally formed by adjusting the temperature during the underfilling operation.

## Description

### Cross Reference to Related Applications

This application claims the benefit of U.S. Provisional Application No. 60/443,029, filed January 28, 2003, the disclosure of which is hereby incorporated by reference herein in its entirety.

### Field of the Invention

This invention relates generally to semiconductor packaging and, more particularly, to the underfilling of gaps between a component and a component carrier.

### Background of the Invention

Microelectronics manufacturers routinely mount, a component, such as a die, on a component carrier, such as a substrate, a printed circuit board, or a lead frame, to form a package. In chip scale packages (CSP), wafer level packages (WLP), direct chip attach packages (DCA), ball grid array packages (BGA), flip chip packages, and through-hole packaging, electrically-conductive contacts, known as bond pads, on a component are electrically coupled with corresponding electrically-conductive contacts, known as solder balls or bumps, on a component carrier. Typically, the component is positioned relative to the component carrier to register the solder bumps with the bond pads and a reflow process is applied to create electrical connections in the form of solder joints between the component and the component carrier. Flip chip packages and chip scale packages incorporate a space or gap between the component and the component carrier. Other mounting arrangements, such as mounting a component carrier to a printed circuit board by ball-pad electrical contacts, may also incorporate a space or gap.

The component and the component carrier are usually formed of different materials having mismatched coefficients of thermal expansion. When heated, the component and the component carrier experience significantly different dimensional changes that create significant thermally-induced strains in the electrical connections between the component and the component carrier. The disparity in thermal expansion can result in degradation in the performance of the component, damage to the solder joints, or package failure. As the size of the component increases, the effect of a mismatch in the thermal expansion between the component and the component carrier becomes more pronounced.

Filling the gap between the component and the component carrier with an encapsulant or underfill material improves the reliability of the electrical connections in component-component carrier assemblies. Underfilling isolates the electrical connections from exposure to the ambient environment and lends mechanical strength to the assembly for resisting dynamic and static mechanical loadings. The underfill material also increases the fatigue life of the package and reduces the stress experienced by the electrical connections during thermal cycling or when the component and the component carrier have a significant temperature differential. The underfill material further provides a thermally conductive path that removes heat from the component and that operates to reduce any temperature differential between the component and the component carrier. As a result, underfilling significantly increases the operational lifetime of the package.

Various conventional techniques may introduce the underfill material into the gap between the component and the component carrier. One such conventional method relies on surface-tension wetting or capillary action to induce movement of a heated, low-viscosity underfill material characterized by strong wetting characteristics from a side edge into the gap. According to the practice of this conventional method, underfill material is dispensed by an underfill dispenser on the component carrier as an elongated single line, L-shaped bead or U-shaped bead near the side edges of the component. Capillary forces move the underfill material into the gap. The viscosity of the underfill material is frequently reduced and, therefore, the flow rate is increased by pre-heating the component carrier in the vicinity of the attached component to a uniform, steady-state temperature between about 40°C and about 90°C, before the underfill material is dispensed onto the component carrier. The flow rate may also be increased by, for example, applying a pressure differential created across the bead of underfill material to suction the underfill material into the gap. After the underfill material penetrates beneath the component, an additional bead of underfill material may be dispensed about the perimeter of the component to provide a fillet. The underfill material is cured after the electrical connections have been fully encapsulated.

Conventional automated underfilling techniques may produce a wet out area resulting from the underfill material wetting the component carrier outward from the component edges where the fillet is formed. After the component is underfilled, a residue often remains on this wetted area. This residue may be undesirable for cosmetic reasons or may encroach on "keep-out" areas on the component carrier carrying other associated circuitry components, such as passive devices, or vision fiducials. Dams or flow control barriers may be positioned about the component perimeter for controlling the extent of the wet out area. However, positioning the flow control barriers on the component carrier may result in a reduction in the throughput of the underfilling operation.

Conventional underfilling techniques demand precise metering of the dispensed amount of underfill material. The precision metering is required to provide a complete underfill and any required fillet and to limit dispensing of excess underfill material onto the component carrier that may provide a residue or an excessively large fillet width. Generally, the dispensed amount must be constrained between minimum and maximum amounts, which may be calculated, and implemented under statistical process control. The fillet acts as a reservoir that receives any excess underfill material. As a result, the underfill dispenser must be capable of precise volumetric dispensing.

Conventional underfilling techniques may introduce voids in the underfill material arising from irregularities in the movement or flowout of the liquid underfill material from the component side edges into the gap. Such voids may initiate corrosion and cause undesirable thermal stresses that degrade performance or adversely affect the reliability of the package.

Conventional underfilling techniques also require vision to locate the components and to pinpoint fiducial marks on the component carrier. Automated underfill dispensing systems incorporate a vision system with a camera and a complex lighting scheme to aid in programming dispensed patterns and to accurately align the dispensed pattern of underfill material with the component side edges. Such vision systems are expensive and the need for vision protracts underfilling operations.

The dispenser needle of conventional underfilling techniques must be precisely positioning in three dimensions relative to the component and, in particular, relative to the component side edges. Therefore, the underfill dispenser and its dispenser needle must be carried by a movable stage capable of highly accurate positioning.

Yield excursions arising from contact between the dispenser needle and the component and/or component carrier are observed in conventional underfilling techniques. Accurately positioning the dispense height of the discharge outlet of the dispense needle above the component carrier is important for achieving quality underfill operations. If the dispense height is too high, a portion of the dispensed underfill material may stray from the intended bead location. If the dispense height is too low, the dispenser needle may strike the component carrier or component. Although the dispenser needle may be equipped with a contact sensor to detect an excessively-low dispense height, contact sensors add to the cost of the underfill dispensing system.

Conventional underfilling techniques require high-cost, throughput-restricting dispenser needles. Such dispenser needles are required to insure accurate placement of the dispensed bead of underfill material. However, the flow rate of underfill material through the dispenser needle is limited by the lumen diameter.

The flow-out time for the underfill material from side-edge beads into the gap may be significant for conventional underfilling techniques as the underfill material must flow from one or more side edges across the width or diagonal of the gap. Lengthy flow-out times reduce the throughput of the underfilling operation. In addition, the flow of underfill material into the gap may be inhomogeneous or non-uniform, which may produce voids in the cured underfill material. Furthermore, stagnation lines may result from the convergence of the leading edges of various different wavefronts originating from beads flowing into the gap from different component side edges.

Typically, heat is transferred to the underfill material moving in the gap through the component carrier in conventional underfilling techniques. Because the component carrier is a poor thermal conductor, the heating is often inefficient and, therefore, a relatively high wattage heater is required.

It would therefore be desirable to underfill the gap formed between a component, such as a die, and a component carrier, such as a substrate, in a manner that increases the throughput of the underfilling process and that reduces the associated equipment cost.

### Summary of the Invention

The invention overcomes the foregoing and other shortcomings and drawbacks of underfill methods heretofore known. While the invention will be described in connection with certain embodiments, it will be understood that the invention is not limited to these embodiments. On the contrary, the invention includes all alternatives, modifications and equivalents as may be included within the spirit and scope of the invention.

Generally, the invention relates to a method for underfilling a gap between a component, which may be a die, and a component carrier, such as a substrate, to encapsulate a plurality of electrical connections formed therebetween. The principles of the invention are applicable to any component mounted to a component carrier in which a gap or space is present in the mounted assembly. For example, the principles of the invention are applicable to any surface-mounted or throughhole-mounted assembly that incorporates a gap between the component and its component carrier.

According to the principles of the invention, a method is provided for underfilling the gap between a component and a component carrier. The method includes heating the component and the component carrier, introducing underfill material into a passageway defined in one of the component carrier and the component that communicates with the gap, and moving underfill material from the passageway into the gap for encapsulating a plurality of electrical connections extending between the component and the component carrier. The underfill material does not have to be introduced under pressure into the passageway(s) as pressure is not required to initiate flow from the passageway(s) into the gap. The underfill material is dispensed into the passageway(s) wherein gravity and capillary action move the underfill material into the gap. The dispensed volume of underfill material in the passageway(s) operates as a fluid reservoir that is drained by flow out into the gap. However, pressurizing an/or drawing a vacuum or near-vacuum may increase the flow rate of the underfill material.

From the foregoing summary and the detailed description to follow, it will be understood that the invention provides a unique and effective method for underfilling the gap between a component, such as a die, and a component carrier, such as a substrate. The invention eliminates or, at the least, reduces the wet out area associated with conventional underfilling techniques so that "keep-out" areas on the component carrier are preserved. In particular, the underfill material does not wet passive devices positioned on the component carrier adjacent to the component.

The invention also provides for customized sizing of the fillet. The occurrence or non-occurrence of a fillet is controllable by regulating the component temperature. Unless the temperature is intentionally selected to provide a fillet, surface tension at the peripheral edge of the component will halt the outward flow of underfill material and a fillet will not form. Increasing the component temperature forms a fillet that is reproducible among successive underfilling operations for different components.

The invention eliminates the need for'an automated vision system having a camera and a complex lighting scheme as imaging is not required for accurate alignment of the passageway relative to the dispensing head. This increases the throughput and reduces equipment cost. The invention also relaxes the requirements for three-dimensional (X, Y and Z) positioning of the dispenser head, component, and component carrier. Moreover, the need for expensive throughput-restrictive needles is eliminated as the underfill material is not dispensed as a bead but; instead, is merely introduced into one or more passageways extending through either the component carrier or the component.

The risk of yield excursion resulting from needle-component collisions is reduced as the dispensing needle may be positioned on the component carrier side opposite to the component carrier side on which the component is located. The flow-out time from the passageway(s) is significantly reduced as compared with movement of the underfill material from the component side edges into the gap, as the distance that the underfill material must flow from the passageway(s) for filling the gap is reduced.

The invention also eliminates, or reduces the incidence of, stagnation lines. Underfilling from a centrally located passageway or a symmetrical set of passageways results in a generally isotropic radial flow of underfill material. Moreover, the heating of the package is more efficient because heat may be transferred through the component if underfill is introduced into passageway(s) in the component carrier, as compared with conventional underfilling in which heat is transferred through the component carrier, which typically has a lesser thermal conductivity.

The invention also relaxes the requirement for precise volumetric dispensing of the underfill material. Specifically, the minimum amount of underfill material added to the passageway(s) of the various embodiments of the invention is equal to the sum of the volume under the die and the volume of the fillet less the volume of the interconnect bumps. In accordance with the principles of the invention, the volume of underfill material does not need to be precisely regulated, other than introducing the minimum amount of underfill material.

Unless the die is intentionally heated above a threshold temperature, surface tension at the edges of the gap will prevent significant outflow of underfill material beyond the edges of the die. As a result, a significant fillet will not be created during the underfilling operation. Any excess underfill material added to the passageway(s), above and beyond the minimum amount of underfill material, will simply not flow into the gap and will instead remain within the passageway(s) or protrude from the passageway(s) outwardly from the substrate.

In accordance with the principles of the invention, the passageway(s) may be filled by multiple dispensing operations with a dwell time during which underfill material may be dispensed into the passageway or passageways of other packages. This increases process throughput because the dispense process may be performed on certain packages while the underfill material is flowing in other, packages.

After the underfill material is dispensed into the passageway(s), the underfill material begins to move from the passageway or passageways into the gap under capillary action and gravity. The flow out may occur as the package is being transported from the location of the underfill dispenser system to a subsequent location, such as a heated oven for curing the underfill material. This significantly increases process throughput, as compared with conventional underfill operations.

The invention contemplates that underfill material may be added by, for example, a pick-and-place operation to the passageway(s) in a solid form, such as a pellet, or other solid-phase volume. The pellet is melted to liquefy the underfill material, which then flows or moves into the gap.

The invention improves the durability and reliability of electronic components that require the presence of an underfill material. The invention also significantly reduces the time required to effectively and reliably underfill the gap between the component and the component carrier. The invention speeds the overall throughput of the underfilling process, especially for underfilling multiple components carried by a single component carrier, while simultaneously satisfying the need for flexibility and also adapting to multiple different component sizes, reduced gap dimensions, and the various types of underfill material used in the industry.

The above and other objects and advantages of the present invention shall be made apparent from the accompanying drawings and the description thereof.

### Brief Description of the Drawings

The accompanying drawings, which are incorporated in and constitute a part of this specification, illustrate embodiments of the invention and, together with a general description of the invention given above, and the detailed description of the embodiments given below, serve to explain the principles of the invention.
Fig. 1A is a perspective view of a package, following an underfilling operation, that includes of a die, shown in phantom, and a substrate having a fluid passageway according to an embodiment of the invention;
Fig. 1B is a cross-sectional of the package of Fig. 1A after the underfill material is introduced into the fluid passageway;
Fig. 1C is a cross-sectional of the package of Fig. 1A after the underfill material flows from the fluid passageway into the gap between the die and the substrate;
Fig. 1D is a top view of the package of Fig. 1A;
Fig. 1E is a cross-sectional similar to Fig. 1C of an alternative embodiment of the invention;
Fig. 1F is a cross-sectional similar to Fig. 1C of an alternative embodiment of the invention;
Fig. 2 is a cross-sectional similar to Fig. 1C of an alternative embodiment of the invention in which the fluid passageway is provided in the die;
Figs. 2A, 2B and 2C are views similar to Figs. 1A, 1C and 1D in accordance with another alternative embodiment of the invention in which the fluid passageway is circumscribed by a dam;
Fig. 2D is a cross-sectional similar to Fig. 2B of an alternative embodiment of the invention;
Figs. 3A, 3B and 3C are views similar to Figs. 1A, 1C and 1D in accordance with yet another alternative embodiment of the invention in which the fluid passageway has a stepped diameter;
Figs. 4A, 4B and 4C are views similar to Figs. 1A, 1C and 1D in accordance with yet another alternative embodiment of the invention in which a single fluid passageway is defined in the substrate at a location beneath a diagonal of the die;
Figs. 5A, 5B and 5C are views similar to Figs. 1A, 1C and 1D in accordance with yet another alternative embodiment of the invention in which two fluid passageways are defined in the substrate at locations beneath a diagonal of the die; and
Figs. 6A, 6B and 6C are views similar to Figs. 1A, 1C and 1D in accordance with yet another alternative embodiment of the invention in which a plurality of fluid passageways are defined in the substrate at locations beneath the die.

### Detailed Description of the Preferred Embodiments

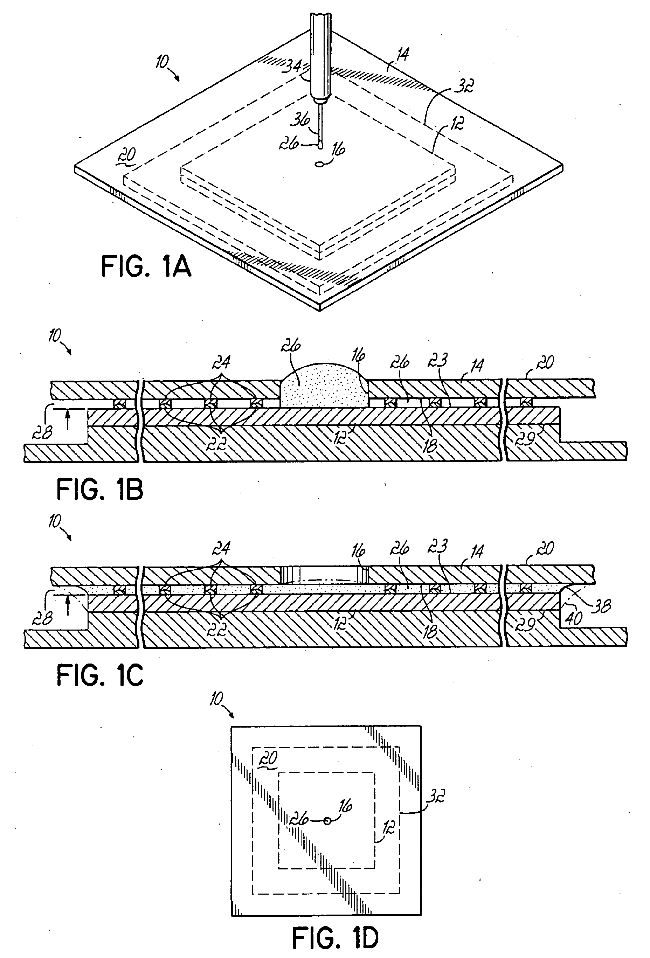

With reference to Figs. 1A-D, a package assembly 10 consists of a component, such as a die 12, mounted on a component carrier, such as a substrate 14. As persons skilled in the art will appreciate, substrate 14 may comprise an organic or ceramic substrate material, such as a printed circuit board, a flip chip multi-chip module or a flip chip carrier, and the die 12 may have any suitable geometry including but not limited to a rectangular geometry. The die 12 is electrically and mechanically connected to the substrate 14 through a group of interconnect bumps 22 on a first side 23 of the die 12 that are registered or aligned with a corresponding group of solder pads 24 on a first side 18 of substrate 14. The solder bumps 22 and solder pads 24 are joined by a reflow process to provide mechanical, thermal and electrical interconnections therebetween in the form of solder joints. The first side 23 of die 12 and the first side 18 of substrate 14 are spaced apart by gap 28. Generally, gap 28 ranges in dimension from about 1 mil (about 25 microns) to about 50 mils (about 1,270 microns). Underfilling according to the principles of the invention is particularly effective for filling gaps 28 ranging from about 12 mils (about 300 microns) to about 23 mils (about 600 microns).

With continued reference to Figs. 1A-D and in accordance with the principles of the invention, the substrate 14 incorporates a fluid chamber or passageway 16 that penetrates through the thickness of substrate 14 between the substantially planar first side 18 and a substantially planar second side 20. The passageway 16 is located at or near the geometrical center of the die 12. An underfill material 26, such as a liquid epoxy or another liquid polymer in an uncured state, is introduced into the gap 28 through passageway 16 as described below. Although the passageway 16 is illustrated as having a circular cross-sectional profile, the invention is not so limited as passageway 16 may have, for example, an oval or rectangular cross-sectional profile.

To that end, a second side 29 of die 12 is placed in thermal contact with a support 32 heated to a dispensing temperature suitable for transferring heat energy to the die 12. It is contemplated by the invention that the die 12 may be heated either by various different contact heating techniques or by different non-contact heating techniques as understood by persons of ordinary skill in the art. The magnitude of the dispensing temperature is selected to assist and facilitate the movement of underfill material 26 into the gap 28. In certain embodiments of the invention, the dispensing temperature, measured at the die 12, may be in the range of about 60°C to about 100°C. The package assembly 10 is inverted during the dispensing operation, as contrasted with conventional underfilling operations.

An underfill dispenser 34 is maneuvered relative to the substrate 14 for dispensing a volume of underfill material 26 into the passageway 16. The underfill dispenser 34 dispenses underfill material 26 received from a dispensing pump (not shown) in a non-contact manner from a discharge opening of a dispenser needle 36 into the passageway 16, as shown in Fig. 1B. The underfill material 26 is in an unpressurized condition while residing within passageway 16. Heat energy originating from support 32 is transferred from the heated die 12 to the underfill material 26 advancing through, or otherwise moving in, the gap 28 from the passageway 16 into the gap 28. The transferred heat elevates the temperature of the underfill material 26 in the gap 28 so as to reduce its temperature-dependent viscosity and to thereby increase the uniformity of the leading edge or wave front of the advancing underfill material 26. The underfill material 26 flows, or moves, radially outward from passageway 16 and into the gap 28 under the collective influences of gravity and capillary action. The flow-out of underfill material 26 from passageway 16 into gap 28 is substantially radially isotropic. As a result, stagnation lines are unlikely to occur, which significantly improves the homogeneity of the underfill material 26 in the filled gap 28. The flow-out of underfill material 26 ceases or halts at the side edges of the die 12 due to hydrostatic surface tension, as shown in Fig. 1C. The underfill material 26 in gap 28 fully encapsulates all of the electrical interconnections provided by the solder junctions resulting from the reflow of solder bumps 22 and solder pads 24 and, after curing, provides benefits equivalent to conventional underfilling while eliminating incursions of underfill material 26 into "keep-out" areas on substrate 14.

With continued reference to Figs. 1A-D and in accordance with the principles of the invention, a fillet 38 may optionally be formed along the side edges of the die 12, as described in additional detail below. Fillet 38 is illustrated in Fig. 1B as having a negligible width due to the action of surface tension limiting the outward flow at the side edges of die 12. The width of the fillet 38 may be increased, as indicated by the fillet 40 shown in phantom lines, by increasing the dispensing temperature of die 12 at least locally near the outer peripheral edge of die 12 or the temperature of the entire die 12 so that the underfill material 26 adheres to and climbs the peripheral edge of the die 12. The specific dispensing temperature required to create fillet 40 will depend upon the composition of the underfill material 26. Of course, the dispensed volume of underfill material 26 must include an additional volume sufficient to create the fillet 40. In accordance with the principles of the invention, a negligible or zero fillet 38 of negligible extent or width is readily provided by controlling the temperature of the die 12. The zero fillet 38 arises due to surface tension acting at the peripheral edge of die 12 so as to halt the outward flow of underfill material 26. The presence of the zero fillet 38 is independent of any excess volume of underfill material 26 dispensed into the passageway 16 beyond the minimum required volume.

The underfill dispenser 34 and dispenser needle 36 may comprise any conventional apparatus capable of dispensing liquid underfill material. One suitable pump for providing underfill material 26 to the underfill dispenser needle 36 is the DJ-9K pump commercially available from Nordson Asymtek (Carlsbad, CA). Underfill dispenser 34, dispenser needle 36, and the associated pump may constitute components of an automated underfill dispensing system, such as the M-2020, the X-1020, M-620 and C-720 underfill dispensing systems commercially available from Nordson Asymtek (Carlsbad, CA). It is contemplated that, because of the relaxed dispensing requirements, the precision in the amount of dispensed underfill material 26 and the positioning of the underfill dispenser needle 36 relative to the passageway 16 may be relaxed so that multiple different types of dispenser needles 36, dispensing pumps and underfill dispensing systems may be used to dispense the underfill material 26 in accordance with the principles of the invention. For example, throughput-restrictive, narrow gauge dispenser needles 36 and dispenser pumps capable of highly accurate volumetric dispensing may be eliminated from the underfill dispensing system. In particular, the gauge of dispenser needle 36 may be increased significantly for reducing the time required to dispense the requisite volume of underfill material 26 into passageway 16, as compared with conventional underfill dispensing that must dispense uniform beads of underfill material 26.

Passageway 16 should have a diameter such that metallization traces on the first side 18 of substrate 14 are not impacted by its presence. The volume of the passageway 16 may be selected to be substantially greater than or equal to the volume of underfill material 26 required to fill the space in gap 28 not occupied by interconnect bumps 22 and to provide any required fillet 40. To that end, a minimum volume of underfill material 26 to accomplish underfilling may be calculated or otherwise determined and, subsequently, at least that minimum volume is dispensed in a single dispensing operation or pass into the passageway 16. Typically, the dispensed volume of underfill material 26 is about 100 mm³ to about 150 mm³. Dispensing underfill material 26 into the passageway 16 eliminates the need to dispense one or more beads of underfill material 26 in one or more passes proximate to the side edges of the die 12, as is conventional. As a result, the underfill dispenser 34 and dispenser needle 36 may remain stationary during a dispensing operation and the positioning requirement of the die 12 relative to the dispenser needle 36 is relaxed.

The volume or capacity of the passageway 16 may be less than the required minimum volume of underfill material 26 if, for example, the size of the passageway 16 would interfere with the metallization traces or the die 12 is dimensionally large. In these instances, multiple dispensing operations or passes may be required to accomplish the underfilling operation of gap 28. It is further appreciated that, unless the die temperature is intentionally raised to generate a fillet 40, the amount of underfill material 26 flowing from passageway 16 into gap 28 will be equal to the minimum volume due to surface tension at the side edges of the die 12 that produces a zero fillet 38. The addition of an excess of underfill material 26 to the passageway 16 will not result in the appearance of fillet 40, unless the die temperature is intentionally raised for overcoming surface tension at the peripheral edge of die 12. If the temperature is not intentionally raised to produce fillet 40, any excess underfill material 26 will merely remain resident in passageway 16 and may form a crown or other shaped form in, or projecting out of, passageway 16, as indicated in phantom in Fig. 1C.

The invention contemplates that, in alternative embodiments, the flow rate of underfill material 26 from passageway 16 into gap 28 may be increased by, for example, applying a pressure differential at one or more of the side edges of the gap 28. The suction created by the pressure differential assists the flow of underfill material 26 into the gap 28.

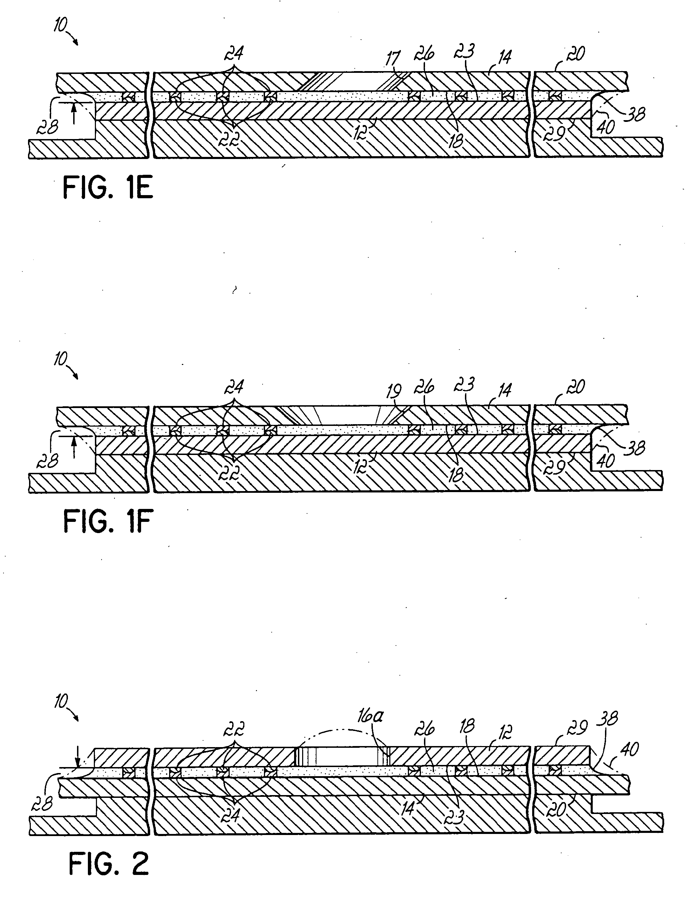

With reference to Fig. 1 E and in accordance with an alternative embodiment of the invention, an inclined fluid chamber or passageway 17 is provided in the substrate 14. The centerline of the fluid passageway 17, about which the sidewall of the passageway is centered, is oriented at an angle relative to the planar first and second sides 18, 20 of substrate 14. This inclined orientation differs from the normal orientation of passageway 16 (Figs. 1A-D).

With reference to Fig. 1F and in accordance with another alternative embodiment of the invention, a tapered fluid chamber or passageway 19 is provided in the substrate 14. The fluid passageway 19 narrows in diameter in a direction from the second side 20 to the first side 18, although the invention is not so limited as passageway 19 may taper in the opposite direction. This inclined orientation differs from the orientation of passageway 16 shown Figs. 1A-D as normal to second side 20.

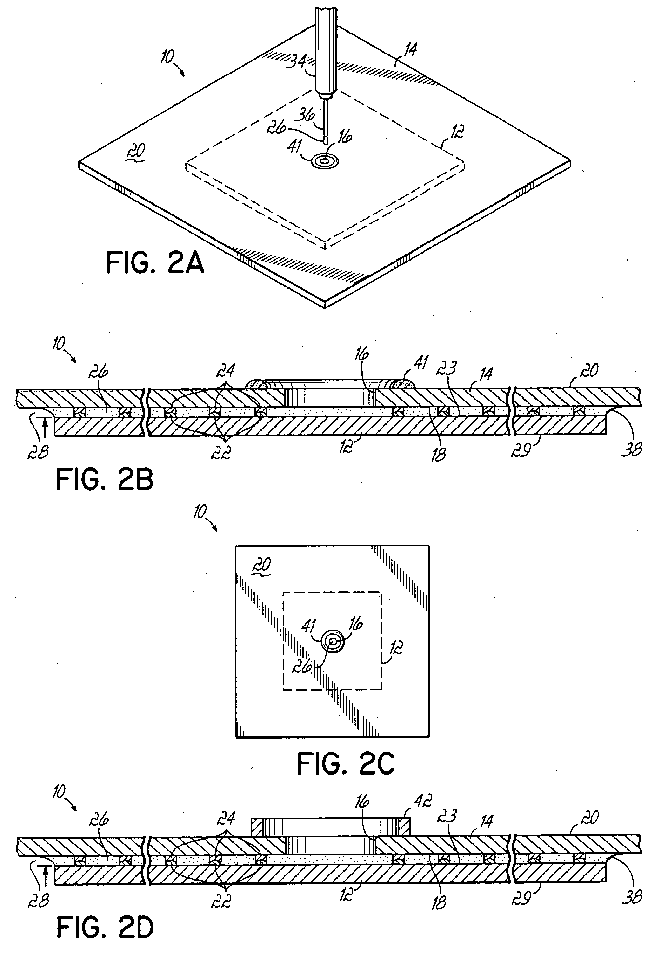

With reference to Fig. 2 and in accordance with yet another alternative embodiment of the invention, a fluid passageway 16a, similar to passageway 16, may be formed in the die 12, rather than in the substrate 14. The characteristics of the passageway 16a penetrating through the die 12 are identical to the characteristics of passageway 16 described above. The die 12 is positioned relative to the substrate 14 and at least the substrate 14 is heated to a dispensing temperature by placing the substrate 14 in thermal contact with heated support 32 before the underfill material 26 is dispensed into fluid passageway 16a, as described above and as shown in Fig. 1B. Flow out proceeds from fluid passageway 16a, as described above for fluid passageway 16 to fill the gap 28. In alternative embodiments, passageway 16a may be inclined similar to passageway 17 (Fig. 1E) or may be tapered similar to passageway 19 (Fig. 1F).

With reference to Figs. 2A-C in which like reference numerals refer to like features in Figs. 1A-C, a flow control barrier or dam 42 is positioned about the outer circumference of the fluid passageway 16 with a surrounding or circumscribing relationship. The dam 42 is formed by a dispensing operation. As described above in the context of Fig. 2A, a volume of underfill material 26 is dispensed from the dispenser needle 36 of underfill dispenser 34 into passageway 16 and inside the boundary defined by dam 42. Dam 42 has a fluid seal with the second side 20 of substrate 14 adequate to prevent significant loss of underfill material 26 dispensed into the passageway 16 from the volume defined within the interior of dam 42. The invention contemplates that dam 42 may be used with the embodiment shown in Figs. 2A-C for increasing the capacity of passageway 16a.

The presence of dam 42 effectively increases the volume of passageway 16 and defines a portion of a passageway that effectively has a stepped diameter. It follows that dam 42 may permit the required minimum volume of underfill material 26 to be dispensed in a single dispensing operation and/or may permit adjustment of the dimensions of passageway 16 because the volume of passageway 16 may be less than the dispensed volume of underfill material 26. This may aid in instances where the metallization traces or die size limit the passageway volume. The underfill material 26 flows or moves radially outward from passageway 16 and into the gap 28. After the flow-out ceases due to hydrostatic surface tension at the side edges of the die 12, the underfill material 26 fully encapsulates all of the electrical interconnections provided by the solder junctions formed by reflow of solder bumps 22 and solder pads 24. With reference to Fig. 2D, the dam 42 may alternatively be manufactured as a pre-formed gasket that is applied to the second side 20 of substrate 14.

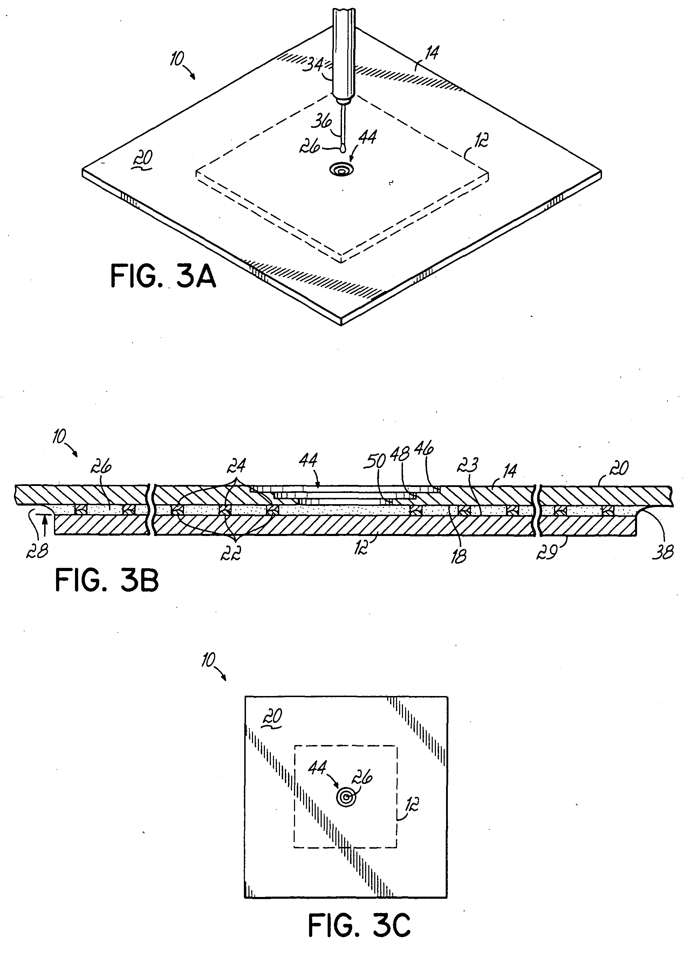

With reference to Figs. 3A-C in which like reference numerals refer to like features in Figs. 1A-C, a fluid chamber or passageway 44 is provided in substrate 14 near the geometrical center or mid-point of the die 12. Passageway 44 is constituted by a stepped bore having a plurality of, for example, three adjoining, individual bores or passageway segments 46, 48, and 50 of differing diameter. The collective volume of the passageway segments 46, 48, and 50 determines the fluid capacity of the passageway 44 and a corresponding maximum volume of underfill material 26 that may be dispensed into passageway 44. As a result, the diameter of the portion of passageway 44 immediately beneath the die 12 may be controlled while providing a cavity of sufficient dimension in the substrate 14 to receive the required volume of underfill material 26 in a single dispensing operation or pass. In particular, the reduced diameter of passageway segment 50 reduces the effective diameter of passageway 44 at its emergence on the first side 18 of substrate 14 for avoiding any nearby metallization traces but, simultaneously, permits the capacity of the passageway 44 to be effectively increased. The invention contemplates that passageway 16a (Fig. 2) may be altered with a stepped diameter for increasing the capacity of passageway 16a.

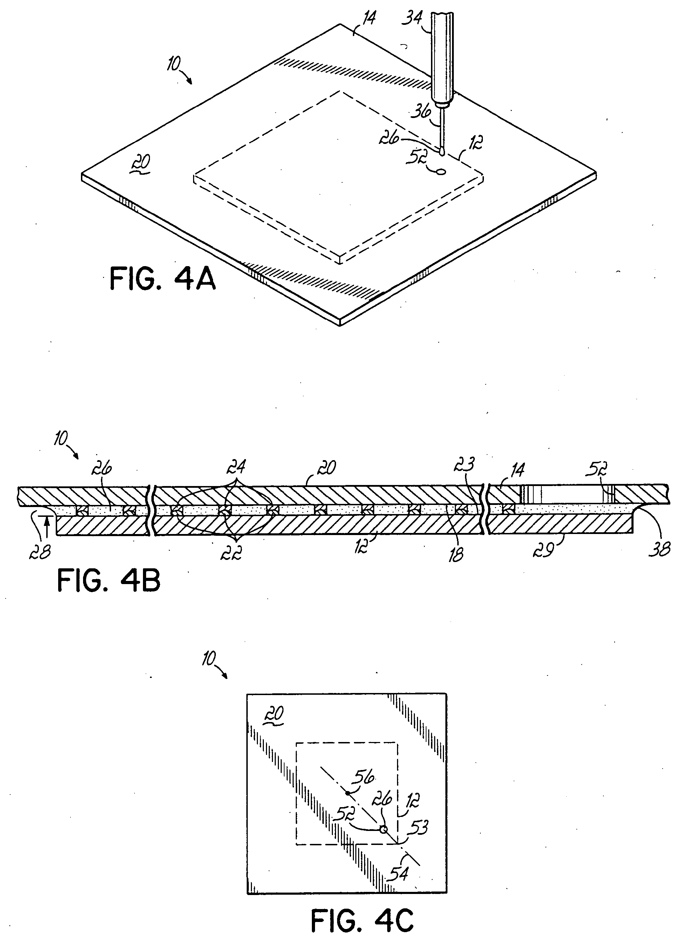

With reference to Figs. 4A-C in which like reference numerals refer to like features in Figs. 1A-C, a fluid chamber or passageway 52 is formed in substrate 14 near one corner 53 of die 12 and beneath a diagonal 54 of the die 12 extending from a mid-point 56 to the corner 53. The passageway 52 may be dimensioned to receive the required volume of underfill material 26 in a single dispensing operation or pass or may be modified with dam (Figs. 2A-C) or with a diametrical series of passageway segments (Figs. 3A-C). Underfill material 26 flows or moves radially away from passageway 52 for filling gap 28. After the flow-out ceases due to hydrostatic surface tension at the side edges of the die 12, the underfilling operation is completed and the underfill material 26 fully encapsulates all of the electrical interconnections provided by the solder junctions. The invention contemplates that passageway 16a (Figs. 2A-C) in die 12 may be repositioned along a diagonal of die 12 as described with regard to passageway 52 in substrate 14.

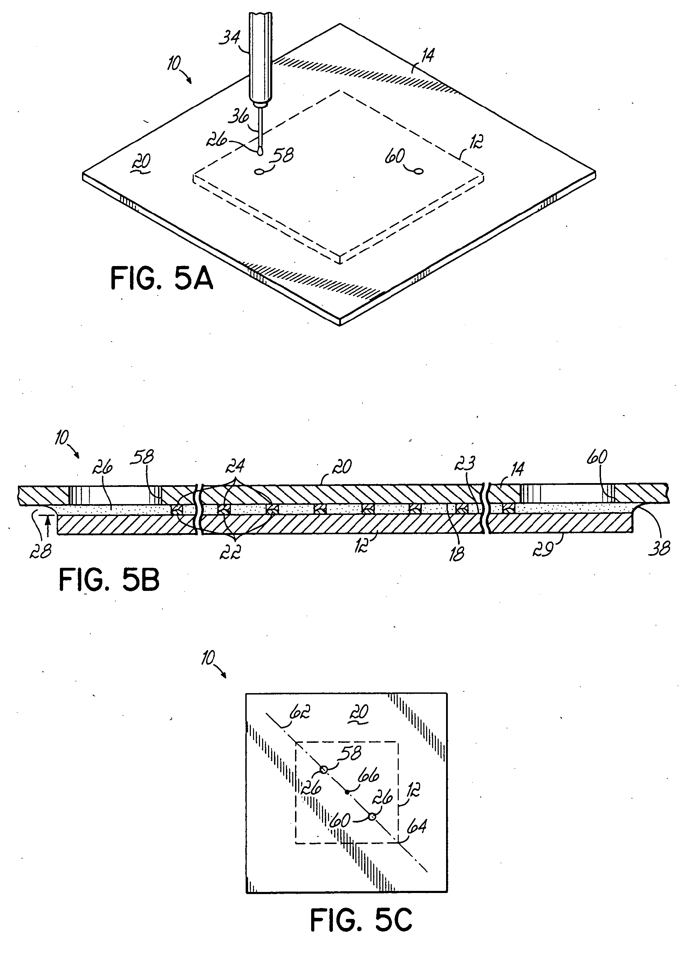

With reference to Figs. 5A-C in which like reference numerals refer to like features in Figs. 1A-C, a plurality of two spaced-apart fluid chambers or passageways 58, 60 are formed in substrate 14 on a diagonal 62 connecting opposite corners 63, 64 of die 12 and that extends through die mid-point 66. The passageways 58, 60 may be positioned, for example, at the respective center of a corresponding quadrant of the die 12. The underfill material 26 flows or moves radially outward from each of the passageways 58, 60 and into the gap 28. Underfill material 26 flowing as an individual wavefront from each of the passageways 58, 60 converges inside the gap 28 and merges into a continuous layer. Hydrostatic surface tension halts the flow-out at the side edges of the die 12, at which time the underfill material 26 fully encapsulates all of the electrical interconnections provided by the solder junctions. The invention contemplates that one or more additional passageways, similar to passageway 16a, may be provided in die 12 consistent with the embodiment of the invention shown in Fig. 2.

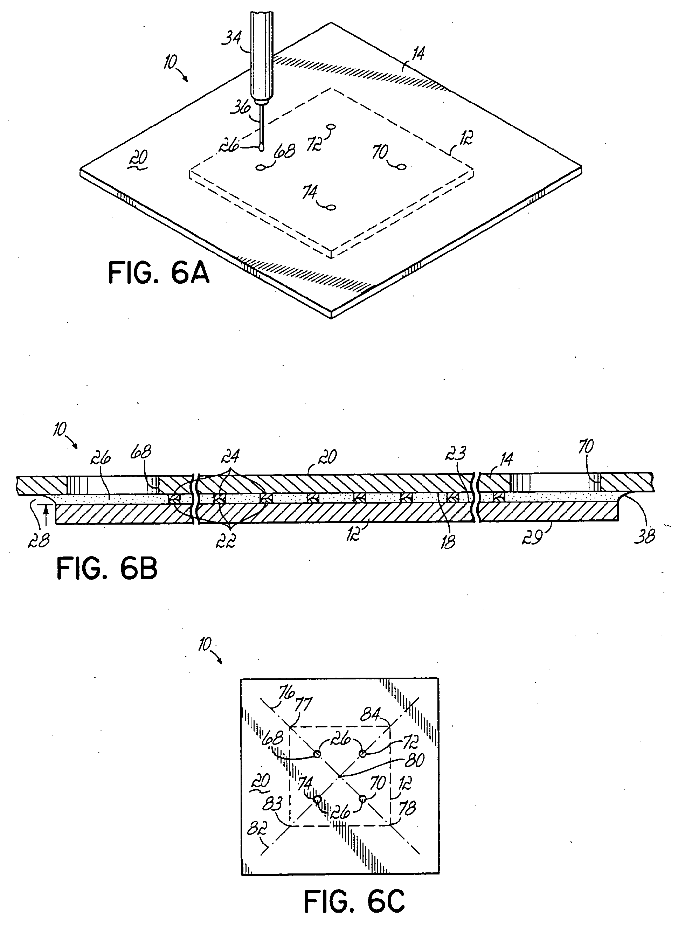

With reference to Figs. 6A-C in which like reference numerals refer to like features in Figs. 1A-C, a plurality of four fluid chambers or passageways 68, 70, 72 and 74 are formed in substrate 14 and beneath die 12. The passageways 68, 70, 72, and 74 are arranged in a quadrilateral with each passageway 68, 70, 72, and 74 located near the center of a corresponding quadrant of the quadrilateral, although the invention is not so limited. Passageways 68 and 70 are located on a diagonal 76 connecting opposite corners 77, 78 of die 12 that extends through a die mid-point 80. Passageways 72 and 74 are located on a diagonal 82 connecting opposite corners 83, 84 of die 12 that extends through the die mid-point 80. Underfill material 26 flows or moves radially outward from each of the passageways 68, 70, 72 and 74 and into the gap 28. Underfill material 26 flowing as an individual wavefront from each of the passageways 68, 70, 72 and 74 converges inside the gap 28 and merges into a continuous layer. Hydrostatic surface tension halts the flow-out at the side edges of the die 12, at which time the underfill material 26 fully encapsulates all of the electrical interconnections provided by the solder junctions.

The invention contemplates that any number of passageways may be provided in either die 12 or substrate 14 for underfilling gap 28 and that the specific locations described herein are exemplary positions and arrangements for the passageway(s). For example, passageway 16 may be located slightly displaced from a location on substrate 14 corresponding to the geometrical center of the die 12. As another example, three passageways may be located along the diagonal 62.

The invention will be further appreciated in light of the following examples.

### Example 1

A substrate was provided with a chamber located near the geometrical center of a 25 mm² glass die that had 22,500 copper bumps on a 150 µm pitch (center-to-center distance between the solder bumps) and a 31 µm gap. The package assembly of die and substrate was inverted and the die was positioned on a heated plate. The die was heated to 65°C and volumes of two different colored underfill materials or underfills were introduced into the chamber. The resultant underfill pattern showed the absence of stagnation lines and indicated the visibility of the flow out speed. The underfill materials filled the gap between the die and substrate with a zero fillet size.

### Example 2

A substrate was provided with a chamber located near the geometrical center of a 25 mm² silicon die that had 22,500 copper bumps on a 150 µm pitch (center-to-center distance between the solder bumps) and a 31 µm gap. The package assembly of die and substrate was inverted and the die was positioned on a heated plate. The temperature of the die was measured to be 65°C. An underfill material or underfill (Hysol 4545) was introduced into the chamber. The underfill material filled the gap between the die and substrate with a zero fillet size.

### Example 3

A package assembly of a substrate and a glass die, having a chamber penetrating through the substrate near the geometrical center, was inverted, the die was positioned on a heated plate, and the assembly was heated to 65°C measured at the die. Two different colored underfill materials or underfills were introduced alternatively into the chamber. The pattern showed the absence of stagnation lines and that the flow out was relatively isotropic. The underfill materials filled the gap between the die and substrate with a zero fillet size.

### Example 4

Two 0.060"-diameter chambers penetrating through the substrate were located on the diagonal of a silicon die configured as in Example 2. The package assembly was inverted and the die was positioned on a heated plate and heated to 95°C measured at the die. A volume of an underfill material or underfill (Hysol 4545) was introduced into the chambers. The underfill operation, initiated when the underfill was introduced into the chambers and concluding when the underfill was completed with underfill material present about the entire periphery of the gap, was observed to be fast (i.e., 94 seconds) and of high quality.

### Example 5

A 0.177"-diameter chamber penetrating through the substrate was located near one corner of a silicon die configured as in Example 2. The package assembly was inverted and the die was positioned on a heated plate and heated to 65°C measured at the die. A volume of an underfill material or underfill (Hysol 4545) was introduced into the chamber. The underfill operation was observed to be fast (i.e., 84 seconds) and of high quality.

### Example 6

Two 0.177"- diameter chambers penetrating through the substrate were located on the diagonal of a silicon die configured as in Example 2. The package assembly was inverted and the die was positioned on a heated plate and heated to 95°C measured at the die. An underfill material or underfill (Hysol 4545) was introduced into the chambers. The underfill operation was observed to be fast (i.e., 68 seconds) and of high quality. Although the chambers of Example 6 were larger in diameter than the chambers of Example 8, the flow-out time was similar to the flow-out time observed in Example 8.

### Example 7

Two 0.125"-diameter chambers penetrating through the substrate were located on the diagonal of a silicon die configured as in Example 2. The package assembly was inverted and the die was positioned on a heated plate and heated to 65°C measured at the die. An underfill material or underfill (Hysol 4545) was introduced into the chambers. The underfill operation was observed to be fast (i.e., 130 seconds) and of high quality. A slight shadowing (stagnation line) was apparent where the two wave fronts of underfill united.

### Example 8 and Comparative Example 1

Three package assemblies, each identical to the package assembly of Example 7, were provided and the corresponding chambers were filled with underfill material or underfill (Hysol 4545). During the underfilling operation, the temperature of the die was 95°C, rather than 65°C as in Example 7. The underfill operation for the three package assemblies was observed to be completed on average in about 40 seconds, with the fastest underfill operation observed to take 38 seconds to complete after introduction of the volume of underfill material into the chambers.

In comparison, a standard capillary underfill operation was performed for the same type of package assembly and temperature of Example 8, using multiple dispenses or passes of L-shaped beads of the same underfill material. The underfill operation was observed to require 118 seconds to complete.

### Example 9

A 0.177"-diameter chamber penetrating through the substrate was located offset from the geometrical center of a silicon die configured as in Example 2 and on a diagonal near the mid-point between the corner and center. The package assembly was inverted and the die was positioned on a heated plate. The temperature of the die was measured to be 95°C. An underfill material or underfill (Hysol 4545) was introduced into the passageway. The underfill operation was observed to take 483 seconds to complete. A fillet was observed to result from adding extra material in the chamber and increasing the temperature locally along the side edge of the die above 95°C.

### Example 10

A package assembly similar to that of Example 9 was provided and the chamber filled with underfill material or underfill (Hysol 4545). During the underfilling operation, the temperature of the die was 65°C. The underfill operation was observed to be completed in 483 seconds.

### Example 11

Four 0.060"-diameter chambers penetrating through the substrate were located near mid-quadrant of each quadrant of a silicon die configured as in Example 2. The package assembly was inverted and the die was positioned on a heated plate and heated to 95°C measured at the die. An underfill material or underfill (Hysol 4545) was introduced into the chambers. Although the underfill operation was observed to be fast (70 seconds) and of relatively high quality, a void occurred in the center of the die. Such voids are particularly insignificant if no bumps are located within the area of the void.

### Example 12

With reference to Figs. 15 and 24, a 0.060"-diameter chamber penetrating through the substrate was located near the geometrical center of silicon die configured as in Example 2. A dam was positioned concentric with the chamber. The package assembly was inverted and the die was positioned on a heated plate. The temperature of the die was measured to be 65°C. An underfill material or underfill (Hysol 4545) was introduced into the cavity. The underfill operation was observed to take 287 seconds to complete.

While the present invention has been illustrated by a description of various embodiments and while these embodiments have been described in considerable detail, it is not the intention of the applicants to restrict or in any way limit the scope of the appended claims to such detail. Additional advantages and modifications will readily appear to those skilled in the art. The invention in its broader aspects is therefore not limited to the specific details, representative methods, and illustrative examples shown and described. Accordingly, departures may be made from such details without departing from the spirit or scope of applicants' general inventive concept.

## Claims

1. A method of underfilling a gap between a component and a component carrier to encapsulate a plurality of electrical connections extending therebetween, one of the component carrier and the component including a passageway that communicates with the gap, the method comprising:
heating the component and the component carrier;
introducing underfill material into the passageway; and
moving underfill material from the passageway into the gap for encapsulating the plurality of electrical connections.

2. The method of claim 1 wherein introducing underfill material further comprises:
filling at least a portion of the passageway with underfill material before significant movement of underfill material into the gap.

3. The method of claim 1 wherein the passageway is located at a geometrical center of the one of the component carrier and the component.

4. The method of claim 1 wherein the passageway is offset from a geometrical center of the one of the component carrier and the component.

5. The method of claim 1 wherein the component and the component carrier are heated before the underfill material is introduced into the passageway, and the method further comprises:
maintaining the component at a substantially constant temperature until the plurality of electrical connections are encapsulated by the encapsulating material.

6. The method of claim 1 wherein heating the component and the component carrier is performed simultaneously with introducing underfill material.

7. The method of claim 1 further comprising:
increasing a temperature of the component and component carrier to form a fillet about an outer peripheral edge of the component.

8. The method of claim 1 wherein a volumetric capacity of the passageway is less than a volume of underfill material required to underfill the gap.

9. The method of claim 8 further comprising:
repeating the steps of introducing and moving until the gap is substantially filled with underfill material.

10. The method of claim 8 further comprising:
placing a flow control barrier about the passageway before the underfill material is introduced into the passageway for increasing the volumetric capacity of the passageway.

11. The method of claim 1 further comprising:
placing a flow control barrier about the passageway before the underfill material is introduced into the passageway.

12. The method of claim 11 further comprising:
dispensing the flow control barrier about the passageway.

13. The method of claim 1 wherein introducing the underfill material further comprises:
dispensing the underfill material in a liquid-phase into the passageway.

14. The method of claim 1 wherein introducing the underfill material further comprises:
placing a solid-phase volume of underfill material into the passageway that converts into a liquid phase during heating.

15. The method of claim 1 wherein heating the component and component carrier further comprises:
transferring heat energy directly to the component carrier from a heat source.

16. The method of claim 1 wherein heating the component and component carrier further comprises:
transferring heat energy directly to the component from a heat source.

17. The method of claim 1 further comprising a plurality of passageways, and introducing the underfill material further comprises:
dispensing the underfill material into each of the plurality of passageways.

18. The method of claim 17, wherein the plurality of passageways are symmetrically arranged about a geometrical center of the one of the component and the component carrier.

19. The method of claim 1 wherein the passageway is defined in the component carrier.

20. The method of claim 1 wherein the passageway includes first and second bores that differ in diameter.

21. The method of claim 20 wherein the first bore is defined by a flow control barrier, and further comprising:
placing the flow control barrier about the second bore before the underfill material is introduced into the passageway.

22. The method of claim 1 wherein the passageway is tapered.

23. The method of claim 1 wherein the passageway is inclined relative to a planar surface of the one of the component and the component carrier defined at a boundary with the gap.

24. A method of underfilling a gap between a component and a component carrier to encapsulate a plurality of electrical connections extending therebetween, comprising:
positioning a dispenser relative to a passageway defined in one of the component carrier and the component that communicates with the gap;
heating the component and the component carrier;
introducing underfill material into the passageway; and
moving underfill material from the passageway into the gap for encapsulating the plurality of electrical connections.

25. The method of claim 24 wherein introducing underfill material further comprises:
filling at least a portion of the passageway with underfill material before significant movement of underfill material into the gap.

26. The method of claim 24 wherein the passageway is located at a geometrical center of the one of the component carrier and the component.

27. The method of claim 24 wherein the passageway is offset from a geometrical center of the one of the component carrier and the component.

28. The method of claim 24 wherein the component and the component carrier are heated before the underfill material is introduced into the passageway, and the method further comprises:
maintaining the component at a substantially constant temperature until the plurality of electrical connections are encapsulated by the encapsulating material.

29. The method of claim 24 wherein heating the component and the component carrier is performed simultaneously with introducing underfill material.

30. The method of claim 24 further comprising:
increasing a temperature of the component and component carrier to form a fillet about an outer peripheral edge of the component.

31. The method of claim 24 wherein a volumetric capacity of the passageway is less than a volume of underfill material required to underfill the gap.

32. The method of claim 31 further comprising:
repeating the steps of introducing and moving until the gap is substantially filled with underfill material.

33. The method of claim 31 further comprising:
placing a flow control barrier about the passageway before the underfill material is introduced into the passageway for increasing the volumetric capacity of the passageway.

34. The method of claim 24 further comprising:
placing a flow control barrier about the passageway before the underfill material is introduced into the passageway.

35. The method of claim 34 further comprising:
dispensing the flow control barrier about the passageway.

36. The method of claim 24 wherein introducing the underfill material further comprises:
dispensing the underfill material in a liquid-phase into the passageway.

37. The method of claim 24 wherein introducing the underfill material further comprises:
placing a solid-phase volume of underfill material into the passageway that converts into a liquid phase during heating.

38. The method of claim 24 wherein heating the component and component carrier further comprises:
transferring heat energy directly to the component carrier from a heat source.

39. The method of claim 24 wherein heating the component and component carrier further comprises:
transferring heat energy directly to the component from a heat source.

40. The method of claim 24 further comprising a plurality of passageways, and introducing the underfill material further comprises:
dispensing the underfill material into each of the plurality of passageways.

41. The method of claim 40, wherein the plurality of passageways are symmetrically arranged about a geometrical center of the one of the component and the component carrier.

42. The method of claim 24 wherein the passageway is defined in the component carrier.

43. The method of claim 24 wherein the passageway includes first and second bores that differ in diameter.

44. The method of claim 43 wherein the first bore is defined by a flow control barrier, and further comprising:
placing the flow control barrier about the second bore before the underfill material is introduced into the passageway.

45. The method of claim 24 wherein the passageway is tapered.

46. The method of claim 24 wherein the passageway is inclined relative to a planar surface of the one of the component and the component carrier defined at a boundary with the gap.

47. The method of claim 24 further comprising:
attaching the component to the component carrier by forming the plurality of electrical connections.
